# EUROPEAN PATENT APPLICATION

(11) **EP 3 451 115 A1**
(43) Date of publication of application: **06.03.2019**
(21) Application number: 17806745.0
(22) Date of filing: 31.05.2017
(51) Int. Cl.: G06F 1/16, H05K 5/02, H05K 7/14

(54) **HINGE FOR ELECTRONIC DEVICE, AND ELECTRONIC DEVICE**

(30) Priority: 31.05.2016 JP 2016109080
(71) Applicant: GVIDO MUSIC CO., LTD., Shinagawa-ku, Tokyo 1400002 (JP)
(72) Inventor: TADANO Junichi, Azumino-shi Nagano 399-8282 (JP); HONDA Nobuhiro, Azumino-shi Nagano 399-8282 (JP)
(74) Representative: Intellectual Property Services GmbH
(86) International application number: PCT/JP2017/020306
(87) International publication number: WO 2017/209194

(57) **Abstract**

Provided is a hinge for an electronic device, whereby display units of the electronic device can be made flat. In the case of the hinge for the electronic device according to the present invention: the electronic device has at least a first display unit and a second display unit and at least a first housing unit and a second housing unit; and the hinge is equipped with a first elastic sheet for connecting the first display unit with the second display unit, a second elastic sheet for connecting the first housing unit with the second housing unit, and a printed circuit board disposed between the first elastic sheet and the second elastic sheet.

## Description

### TECHNICAL FIELD

The present invention relates to a hinge for an electronic device and an electronic device, and, in particular, to a hinge used for a connection section of an electronic device including a plurality of screens, two screens or more, and an electronic device including the hinge.

### BACKGROUND ART

In recent years, there is a remarkable development of an electronic device which may replace a conventional paper medium along with the paperless trend. In such an electronic device, digitized contents of a document, a diagram, an image, and the like are displayed on a screen, instead of contents of a document, a diagram, an image, and the like printed on a paper medium. To replace a paper medium, the electronic device is requested to be portable like a paper medium, and to display contents that can be viewed as stress-free as viewing the contents printed on a paper medium.

Typical examples of contents to be displayed include an electronic book. However, a variety of types of contents other than books have been made paperless in recent years. Accordingly, an electronic device that is expected to be used not only in a situation of reading a book, but also in a variety of situations, has become requested.

For example, assume a situation where a musical score used during a music performance is displayed on an electronic device. A performer as the user views a screen in a state of being away from the screen by a certain distance. Accordingly, a musical score needs to be displayed on a screen that is large enough to allow the performer to read the musical score. Such an electronic musical score is also requested to allow a wide area to be visually recognized at once like an actual musical score.

When size of a screen is large, a weight of an entire electronic device tends to be large as compared with, for example, one of a paperback size. On the other hand, as an electronic device that is portable as a paper medium, the entire electronic device is requested to be thin and light in weight. For this reason, when a wide display area is requested for a content such as an electronic musical score, reduction in weight of an entire electronic device is a more important object.

To make an electronic device portable while maintaining size of a display area, a foldable electronic device having a plurality of screens, two screens or more, instead of one screen is preferable. On the other hand, for a foldable electronic device having a plurality of screen, two screens or more, it is an object to reduce a thickness of the entire electronic device.

In a conventional foldable electronic device, a thickness of a hinge portion has had an influence on a thickness of the entire electronic device. For this reason, in order to reduce a thickness of the entire electronic device, it is an object to reduce a thickness of a hinge portion as much as possible while durability and strength that can endure repeated opening and closing are obtained.

### CITATION LIST

### PATENT LITERATURE

PATENT LITERATURE 1: JP-A-2010-025242
PATENT LITERATURE 2: JP-A-2013-077257

### SUMMARY OF INVENTION

### TECHNICAL PROBLEM

To achieve an object of reducing a thickness of a hinge, PATENT LITERATURE 1 discloses a hinge device including a hinge shaft, a hinge main body through which the hinge shaft passes in a manner rotatable around a center line thereof, a cam main body that rotates around a center line away from the center line of the hinge shaft in conjunction with the hinge shaft, an engaging body engaged with the cam main body, and an elastic member that energizes one of the engaging body and a cam body to the other. The cam body is not disposed on an outer periphery of the hinge shaft and disposed in a manner shifted from the hinge shaft, so that an external diameter of the hinge shaft including the cam body is made small and a thickness of the hinge device is reduced.

PATENT LITERATURE 2 discloses a hinge unit including a support section fixed to a first housing, and an attaching section that includes a fixing section fixed to a second housing containing a display panel, and is disposed on a lower side of the display panel in a manner shifted from the support section in a width direction of the second housing. A guide section is formed on the attaching section in an extending direction of a reinforcing section, and the guide section guides a cable. In this manner, reduction in a thickness of the second housing containing the display panel is achieved while reduction in rigidity of the second housing is restricted.

However, a certain degree of thickness is required for a hinge device having the above mechanical structure due to a structure including a combination of components, and there is a limit on reducing a thickness. Due to the mechanical structure, a width of a hinge portion is large in a state where a device is opened. In particular, in an electronic device having two screens, a distance between the screens is large, causing a problem that visibility is impaired. By employing the mechanical structure, there has been a problem that weights of the hinge portion and the entire device are increased.

In view of the above, to achieve the above objects, the present invention provides a hinge in which a thickness of hinge having a mechanical structure is reduced and an electronic device that employs the hinge.

### SOLUTION TO PROBLEM

To achieve the above object, the present invention provides a hinge using an elastic sheet.

According to a first aspect of the present invention, there is provided a hinge for an electronic device. The electronic device includes at least a first display unit and a second display unit, and at least a first housing unit and a second housing unit. The hinge includes a first elastic sheet that connects the first display unit and the second display unit, a second elastic sheet that connects the first housing unit and the second housing unit, and a printed circuit board provided between the first elastic sheet and the second elastic sheet.

In the hinge for an electronic device according to the first aspect of the present invention, the printed circuit board extends from between the first display unit and the first housing unit to between the second display unit and the second housing unit.

In the hinge for an electronic device according to the first aspect of the present invention, the first elastic sheet and the second elastic sheet are made from rubber.

In the hinge for an electronic device according to the first aspect of the present invention, the printed circuit board is a flexible printed circuit board.

There is also provided an electronic device including the hinge for an electronic device according to the first aspect of the present invention. The electronic device includes a sub-control unit attached to the first housing unit, and a main control unit that is attached to the second housing unit and controls the sub-control unit. The sub-control unit and the main control unit are connected by the printed circuit board.

According to a second aspect of the present invention, there is provided a hinge for an electronic device. The electronic device includes at least a first display unit and a second display unit, and at least a first housing unit and a second housing unit. The hinge includes at least one or more first sections, at least one or more second sections, and at least one or more third sections. The first section of the hinge includes a first elastic sheet that connects the first display unit and the second display unit, a second elastic sheet that connects the first housing unit and the second housing unit, and a printed circuit board provided between the first elastic sheet and the second elastic sheet. The second section of the hinge includes a third elastic sheet that connects the first display unit and the second housing unit. The third section of the hinge includes a fourth elastic sheet that connects the first housing unit and the second display unit.

In the hinge for an electronic device according to the second aspect of the present invention, the printed circuit board extends from between the first display unit of the first section of the hinge and the first housing unit to between the second display unit and the second housing unit.

In the hinge for an electronic device according to the second aspect of the present invention, the first elastic sheet to the fourth elastic sheet are made from rubber.

In the hinge for an electronic device according to the second aspect of the present invention, the printed circuit board is a flexible printed circuit board.

In the hinge for an electronic device according to the second aspect of the present invention, the second section of the hinge and the third section of the hinge are disposed alternately in a longitudinal direction of the hinge.

There is also provided an electronic device including the hinge for an electronic device according to the second aspect of the present invention. The electronic device includes a sub-control unit attached to the first housing unit, and a main control unit that is attached to the second housing unit and controls the sub-control unit. The sub-control unit and the main control unit are connected by the printed circuit board.

In the present invention, a flexible printed circuit board refers to a flexible printed circuit (FPC).

### ADVANTAGEOUS EFFECTS OF INVENTION

According to the present invention, a thickness of a hinge is reduced by using an elastic sheet. In this manner, a thickness of an entire electronic device is reduced, and a display unit of two screens or more of the electronic device can be set in a flat state.

Other purposes, characteristics, and advantages of the present invention will be made clear by an embodiment of the present invention described below in relation to the accompanying drawings.

### BRIEF DESCRIPTION OF DRAWINGS

FIG. 1A is a diagram showing a state in which an electronic device including a hinge of the present invention is opened.
FIG. 1B is a diagram showing a state in which the electronic device including the hinge of the present invention is closed.
FIG. 1C is a side view showing a state in which the electronic device including the hinge of the present invention is closed.
FIG. 2 is a diagram showing an internal structure of the electronic device including the hinge of the present invention.
FIG. 3 is a perspective view enlarging a portion of the hinge of the present invention.
FIG. 4 is a diagram showing each section expanded in an orthogonal direction in a cross section cut along A-A of FIG. 3.
FIG. 5 is a diagram of the hinge of the present invention viewed from a direction orthogonal to the cross section cut along A-A of FIG. 3.
FIG. 6 is a diagram showing the hinge of the present invention when the electronic device is closed in FIG. 5.
FIG. 7 is a perspective view enlarging a portion of the hinge of the present invention.
FIG. 8 is a diagram showing a cross section cut along B-B of FIG. 7.
FIG. 9 is a diagram showing a cross section cut along C-C of FIG. 7 of the hinge according to a first embodiment of the present invention.
FIG. 10 is a diagram showing an example of arrangement of first to third sections of the hinge according to a second embodiment of the present invention.
FIG. 11A is a diagram showing a cross section cut along D-D of FIG. 10 of the hinge according to the second embodiment of the present invention.
FIG. 11B is a diagram showing a cross section cut along E-E of FIG. 10 of the hinge according to the second embodiment of the present invention.
FIG. 12A is a diagram showing a variation of FIG. 11A of the hinge according to the second embodiment of the present invention.
FIG. 12B is a diagram showing a variation of FIG. 11B of the hinge according to the second embodiment of the present invention.

### DESCRIPTION OF EMBODIMENTS

### First Embodiment

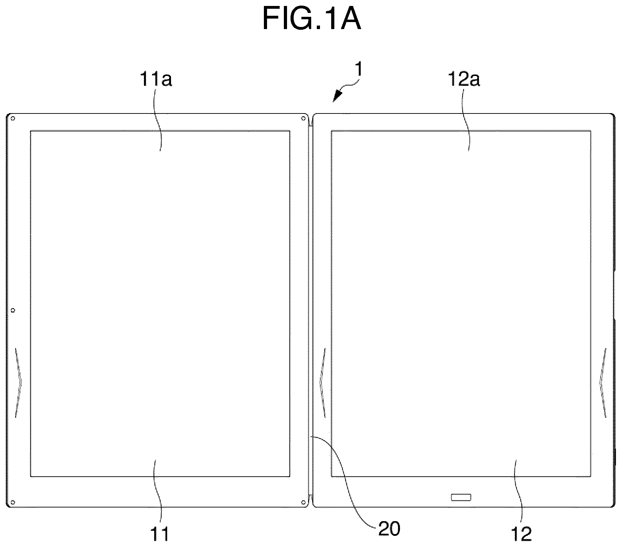

FIG. 1A is a diagram showing a state in which an electronic device 1 including a hinge 20 of the present invention is opened. As shown in FIG. 1A, the electronic device 1 includes at least a first display unit 11 and a second display unit 12. The first display unit 11 and the second display unit 12 are connected by the hinge 20. In a state where the electronic device 1 is opened 180° as shown in FIG. 1A, the first display unit 11 and the second display unit 12 are arranged in a longitudinal direction. The user can view a display screen 11a of the first display unit 11 and a display screen 11b of the second display unit 12 at the same time.

Hereinafter, for simplification, an electronic device including two display screens will be described and illustrated as an example. However, the present invention is not limited to this example, and the hinge 20 of the present invention may be used to connect display units of an electronic device including three or more display screens.

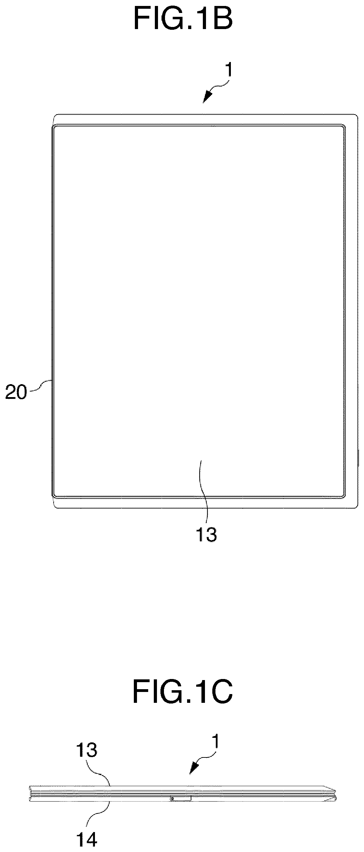

FIG. 1B is a diagram showing a state in which the electronic device 1 including the hinge 20 of the present invention is closed. FIG. 1C is a side view of a state in which an electronic device including the hinge of the present invention is closed. As shown in FIG. 1B, a first housing unit 13 is provided on a back surface of the first display unit 11. Similarly, a second housing unit 14 is provided on a back surface of the second display unit 12. In a state where the electronic device 1 is closed, the display screen 11a of the first display unit 11 of FIG. 1A and the display screen 12a of the second display unit 12 face each other.

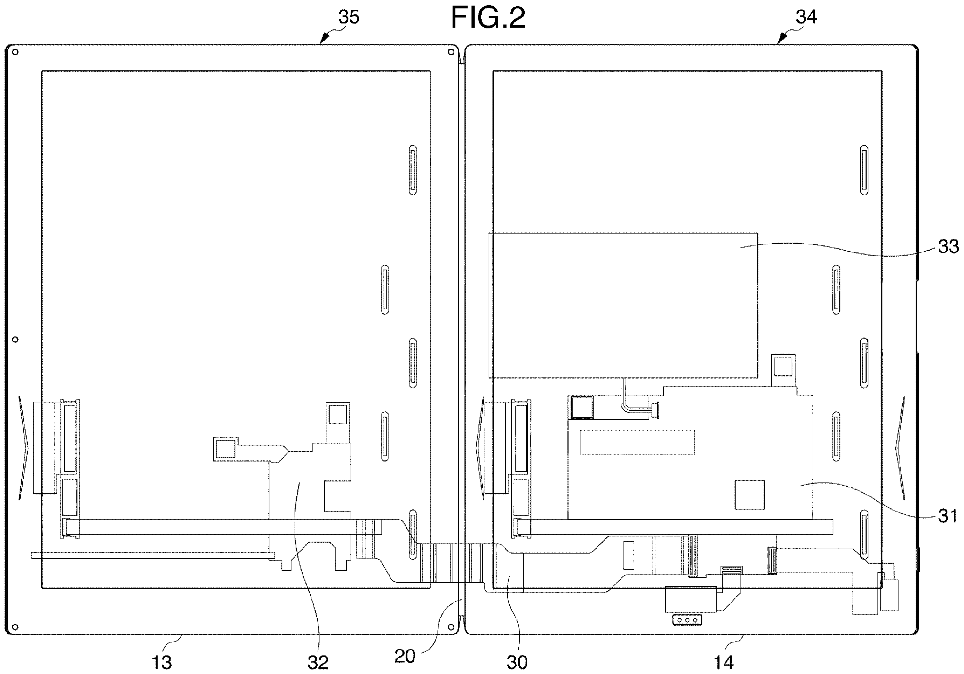

FIG. 2 is a diagram showing an internal structure of the electronic device 1 including the hinge 20 of the present invention. A main control unit 31 that controls the entire electronic device 1 and a battery unit 33 that supplies power to the main control unit 31 are attached to the second housing unit 14. A sub-control unit 32 that controls the first display unit 11 is attached to the first housing unit 13. The main control unit 31 controls the second display unit 12 as well as the sub-control unit 32. The sub-control unit 32 and the main control unit 31 are connected by a printed circuit board 30.

When a side of the electronic device 1 including the second display unit 12 and the second housing unit 14 is a master device 34 and a side of the electronic device 1 including the first display unit 11 and the first housing unit 13 is a slave device 35, the master device 34 including the main control unit 31 can control the slave device 35. For example, a content to be displayed on the display screen 11a on the slave device 35 side can be controlled by the main control unit 31 on the master device 34 side. In this manner, the battery unit 33 and the main control unit 31 do not need to be provided on the master device 34 and the slave device 35 in a duplicate manner, and a weight and a thickness of the entire electronic device 1 can be reduced. On which of the master device 34 and the slave device 35 the devices, such as the main control unit 31, the sub-control unit 32, and the battery unit 33, are arranged can be changed optionally in accordance with a purpose of the electronic device 1.

The printed circuit board 30 is made up of a flexible printed circuit board, and preferably a flexible printed circuit (FPC). The printed circuit board 30 is not limited to a flexible printed circuit board, and may be any flexible circuit board. The printed circuit board 30 has a band shape or a sheet shape, and is freely bendable 360°. The printed circuit board 30 extends from the first housing unit 13 side to the second housing unit 14 side through the hinge 20. In this manner, the printed circuit board 30 connects the sub-control unit 32 of the first housing unit 13 and the main control unit 31 of the second housing unit 14. In FIG. 2, the printed circuit board 30 crosses the hinge 20 in one location of the hinge 20. However, the present invention is not limited to this configuration, and the printed circuit board 30 may cross the hinge 20 in a plurality of locations of the hinge 20.

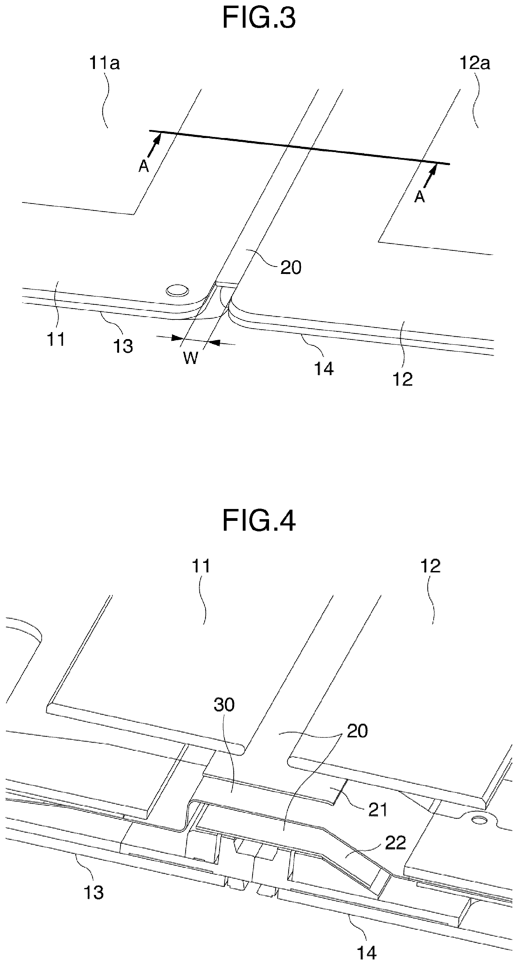

FIG. 3 is a perspective view enlarging a portion of the hinge 20 of the present invention. The hinge 20 includes a portion sandwiched by the first display unit 11 and the first housing unit 13, a portion sandwiched by the second display unit 12 and the second housing unit 14, and a portion exposed to the outside. A width W of the portion exposed to the outside is preferably, for example, 3.3 mm. However, the width W may be, for example, somewhere between 1.0 mm and 20 mm in accordance with a thickness of the first display unit 11 and the first housing unit 13 placed on top of each other, or a thickness of the second display unit 12 and the second housing unit 14 placed on top of each other.

As shown in FIG. 3, the width W of the portion exposed to the outside of the hinge 20 is preferably smaller than a width of an edge portion of the first display unit 11 or the second display unit 12, that is, a portion other than the display screen 11a or 11b. Preferably, the width W is one-third or one-fourth of a width of an edge portion of the display units 11 and 12 or smaller, and may be one-fifth of the width as long as the electronic device 1 is openable and closable. In contrast, when a width of the edge portion of the display units 11 and 12 of the electronic device 1 is small, the width W may be larger than the width of the edge portion of the display units 11 and 12. As the width W of the portion exposed to the outside of the hinge 20 is smaller, a distance between the display screen 11a of the first display unit 11 and the display screen 11b of the second display unit 12 is shorter, which results in a shorter distance of movement of a line of sight when the user views the display screen 11a and the display screen 11b at the same time, and visibility is improved.

FIG. 4 is a diagram showing each section expanded in an orthogonal direction in a cross section cut along A-A of FIG. 3. In a state where the electronic device 1 is assembled, each section is connected. However, for description, each section is floated in FIG. 4. As shown in FIG. 4, the hinge 20 includes a first elastic sheet 21 and a second elastic sheet 22. The printed circuit board 30 is provided between the first elastic sheet 21 and the second elastic sheet 22. The first elastic sheet 21 connects the first display unit 11 and the first housing unit 13 of the electronic device 1, and the second elastic sheet 22 connects the second display unit 12 and the second housing unit 14 of the electronic device 1.

As shown in FIG. 4, the printed circuit board 30 can be disposed in the inside of the first housing unit 13 or the second housing unit 14 in a manner bent vertically in accordance with a shape of the inside instead of in a straight line. In the example of FIG. 4, the printed circuit board 30 crosses the hinge 20 in a location comparatively close to an end of the first housing unit 13 and the second housing unit 14. However, in what portion of the hinge 20 the printed circuit board 30 crosses the hinge 20 is not limited to the above.

The first elastic sheet 21 and the second elastic sheet 22 has a band shape or a sheet shape, has flexibility, and can be freely bent 360°. The first elastic sheet 21 and the second elastic sheet 22 are preferably made from rubber. However, the sheets may be made from other elastomer materials. Materials other than rubber may also be used as long as the material is flexible.

By using an elastic sheet of rubber or the like for the hinge 20, the degree of freedom in bending and stretching is increased, and durability against repeated opening and closing of the electronic device 1 can be obtained. The first elastic sheet 21 and the second elastic sheet 22 preferably constitute a flat surface without a curve in a state where the electronic device 1 is in a state of being opened 180°. By preventing application of an unnecessary tensile force in a state where the electronic device 1 is in a state of being opened 180°, durability can be improved even further. With the first elastic sheet 21 and the second elastic sheet 22 in a flat state when the electronic device 1 is opened 180°, a visual field is not interfered with, a sense of integrity of the display screens 11a and 11b is generated, and improvement in visibility can be expected.

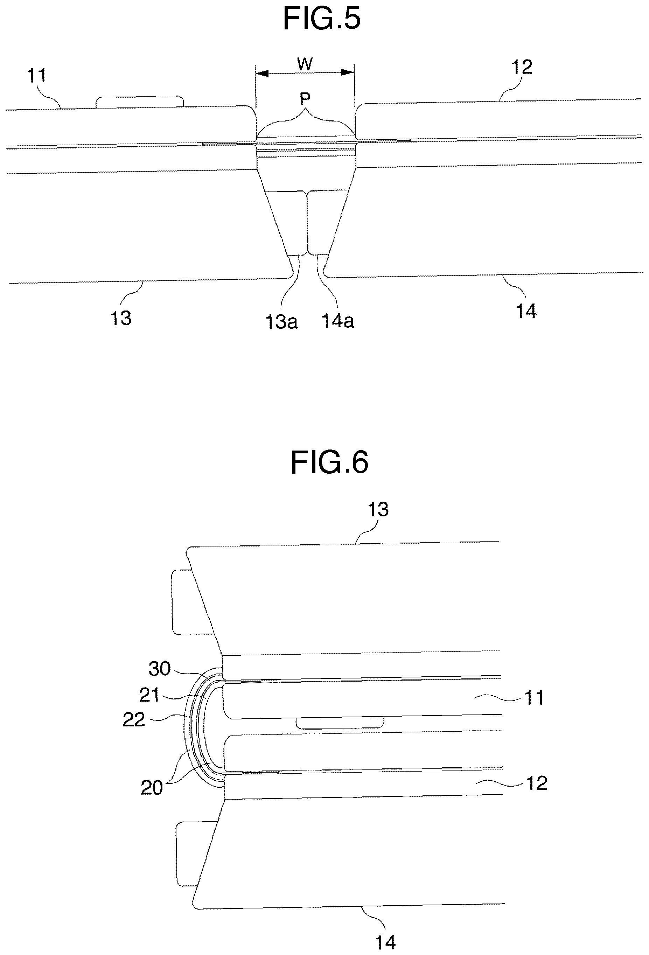

FIG. 5 is a diagram of the hinge of the present invention viewed from a direction orthogonal to the cross section cut along A-A of FIG. 3. In a state where the electronic device 1 is opened 180° as shown in FIG. 3, a display surface of the first display unit 11 and a display surface of the second display unit 12 can be made in a flat state, that is, on the same plane. In a state the display surface of the first display unit 11 and the display surface of the second display unit 12 are on the same plane, the hinge 20 is preferably in a flat state, that is, has a planar shape by being opened 180° at least in an exposed portion P of the hinge 20. The same plane including the display surface of the first display unit 11 and the display surface of the second display unit 12 and the plane of the hinge 20 that is opened 180° are substantially parallel with each other. In a state where the hinge 20 is opened 180°, the first elastic sheet 21, the second elastic sheet 22, and the printed circuit board 30 are also preferably substantially parallel with each other.

When the electronic device 1 is not configured to open beyond 180°, a first support section 13a projecting from the first housing unit 13 may be provided in a direction from the first housing unit 13 toward the second housing unit 14 and a second support section 14a projecting from the second housing unit 14 may be provided in a direction from the second housing unit 14 toward the first housing unit 13 as shown in FIG. 5. With the first support section 13a and the second support section 14a in contact with each other in a state where the electronic device is opened 180°, the electronic device 1 can be prevented from opening beyond 180°. FIG. 5 shows an example of the first support section 13a and the second support section 14a used for preventing the electronic device 1 from opening beyond 180°. However, the configuration is not limited to this example. By changing shapes of the first support section 13a and the second support section 14a, the electronic device 1 may be configured to open to a certain angle, such as 270°.

Further, the electronic device 1 may be configured to substantially open 360° without providing the first support section 13a and the second support section 14a. That is, the hinge 20 may be configured so that the first housing unit 13 or the second housing unit 14 is substantially rotatable 360° around the hinge 20.

FIG. 5 exemplifies a case where a thickness of the first housing unit 13 or the second housing unit 14 is larger than the first display unit 11 or the second display unit 12. However, the configuration is not limited to this example. A thickness of the first display unit 11 or the second display unit 12 and a thickness of the first housing unit 13 and the second housing unit 14 may be the same, or a thickness of the first housing unit 13 or the second housing unit 14 may be smaller than a thickness of the first display unit 11 or the second display unit 12. Even when a thickness of the display units 11 and 12 or the housing units 13 and 14 is changed due to a design change of the electronic device 1, such a change in the thickness can be supported by stretching of the first and second elastic sheets 21 and 22, since the hinge 20 is configured with the first and second elastic sheets 21 and 22.

FIG. 6 is a diagram showing the hinge 20 of the present invention when the electronic device 1 is closed in FIG. 5. In a state where the electronic device 1 is closed, all of the first elastic sheet 21, the second elastic sheet 22, and the printed circuit board 30 are curved at the exposed portion P of the hinge 20. To make the curvature as shown in FIG. 6 possible in a state where the electronic device 1 is closed, gaps are provided between the first elastic sheet 21 and the second elastic sheet 22 and the printed circuit board 30. At this time, a width of a gap between the first elastic sheet 21 and the printed circuit board 30 and a width of a gap between the second elastic sheet 22 and the printed circuit board 30 are not always constant, and one of the widths may be larger than the other. By providing the above gaps, the printed circuit board 30 is allowed to move freely, and the printed circuit board 30 can be prevented from bending excessively.

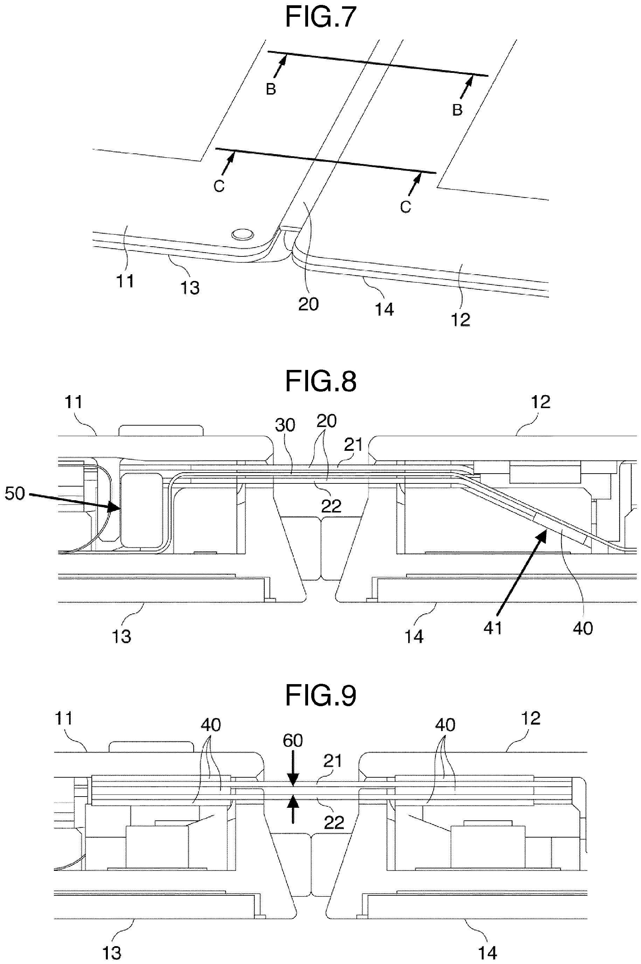

FIG. 7 is a perspective view enlarging a portion of the hinge of the present invention. FIG. 7 shows a state where the electronic device 1 is opened 180°, in which a display surface of the first display unit 11 and a display surface of the second display unit 12 are made in a flat state, that is, on the same plane.

FIG. 8 is a diagram showing a cross section cut along B-B of FIG. 7. In the cross section cut along B-B, the second elastic sheet 22 of the hinge 20 extends longer than the first elastic sheet 21 on the second housing unit 14 side, and the printed circuit board 30 is fixed to the second housing unit 14 by a bonding member 40 at an end portion 41 of the second elastic sheet 22 on the second housing unit 14 side. A space 50 for allowing movement of the printed circuit board 30 and an excess length portion of the printed circuit board 30 are provided on the first housing unit 13 side. By fixing only one side of the printed circuit board 30 as described above, a moving side of the printed circuit board 30 is made clear, and stretching of the printed circuit board 30 can be easily controlled. The bonding member 40 is preferably a double-sided tape. However, the configuration is not limited to the above, and any adhesive agent or adhesive layer having a bond strength may be used.

FIG. 9 is a diagram showing a cross section cut along C-C of FIG. 7. In the cross section cut along C-C, the first elastic sheet 21 on the first display unit 11 side of the hinge 20 is fixed to the first display unit 11 by the bonding member 40, and the second elastic sheet 22 on the first housing unit 13 side of the hinge 20 is fixed to the first housing unit 13 by the bonding member 40. Further, in the cross section cut along C-C, the first elastic sheet 21 fixed to the first display unit 11 and the second elastic sheet 22 fixed to the first housing unit 13 are fixed by the bonding member 40.

Similarly, in the cross section cut along C-C, the first elastic sheet 21 on the second display unit 12 side of the hinge 20 is fixed to the second display unit 12 by the bonding member 40, and the second elastic sheet 22 on the second housing unit 14 side of the hinge 20 is fixed to the second housing unit 14 by the bonding member 40. Further, in the cross section cut along C-C, the first elastic sheet 21 fixed to the second display unit 12 and the second elastic sheet 22 fixed to the second housing unit 14 are fixed by the bonding member 40. A space 60 is provided between the first elastic sheet 21 and the second elastic sheet 22. The space 60 has a width that is at least larger than a thickness of the printed circuit board 30.

### Second Embodiment

A second embodiment of the present invention is the same as the first embodiment of the present invention with respect to the point that the electronic device 1 includes at least the first display unit 11 and the second display unit 12, and at least the first housing unit 13 and the second housing unit 14. The second embodiment of the present invention is different from the first embodiment with respect to the point that the hinge 20 includes at least one or more first sections 20a, at least one or more second sections 20b, and at least one or more third sections 20c. Hereinafter, in the second embodiment, matters which are the same as those in the first embodiment will be omitted from description.

In the second embodiment of the present invention, the first section 20a of the hinge 20 includes the first elastic sheet 21 that connects the first display unit 11 and the second display unit 12, the second elastic sheet that connects the first housing unit 13 and the second housing unit 14, and the printed circuit board 30 provided between the first elastic sheet 21 and the second elastic sheet 22. The second section 20b of the hinge 20 includes a third elastic sheet 23 that connects the first display unit 11 and the second housing unit 14. The third section 20c of the hinge 20 includes a fourth elastic sheet that connects the first housing unit 13 and the second display unit 12.

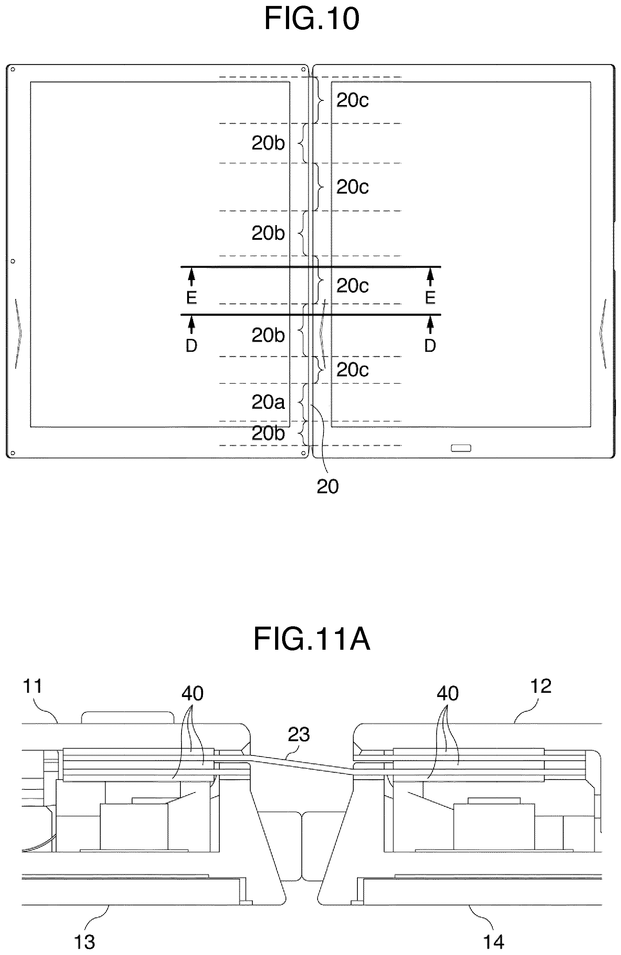

FIG. 10 is a diagram showing an example of arrangement of first to third sections 20a, 20b, and 20c of the hinge 20 according to the second embodiment of the present invention. With respect to sections other than the first section 20a of the hinge 20, the second section 20b and the third section 20c are preferably disposed alternately in a longitudinal direction of the hinge 20.

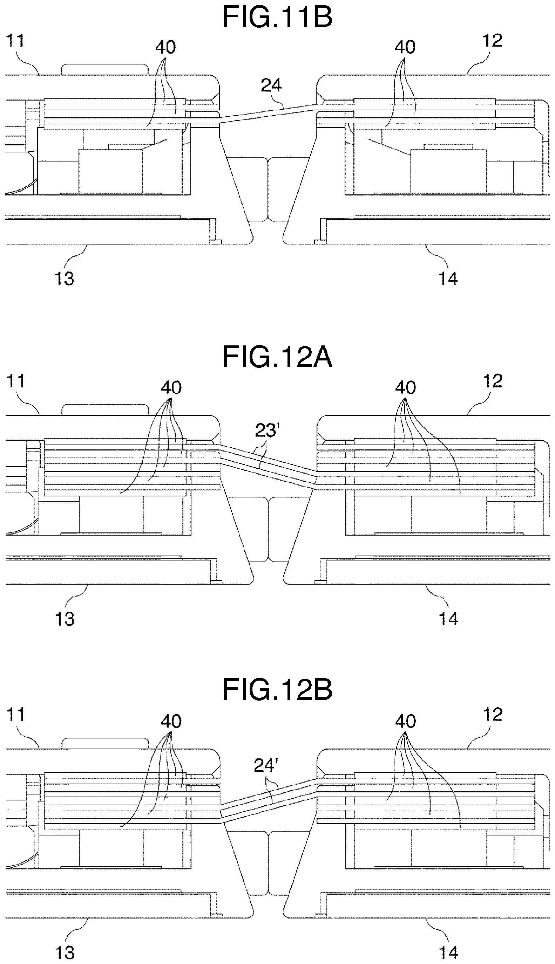

FIG. 11A is a diagram showing a cross section cut along D-D of FIG. 10 of the hinge according to the second embodiment of the present invention. FIG. 11B is a diagram showing a cross section cut along E-E of FIG. 10 of the hinge according to the second embodiment of the present invention. The cross section cut along D-D of FIG. 10 is positioned on the second section 20b of the hinge 20, and the cross section cut along E-E of FIG. 10 is positioned on the third section 20c of the hinge 20.

As shown in FIG. 11A, in the cross section cut along D-D, the third elastic sheet 23 on the first display unit 11 side of the hinge 20 is fixed to the first display unit 11 by the bonding member 40, and the third elastic sheet 23 on the second housing unit 14 side of the hinge 20 is fixed to the second housing unit 14 by the bonding member 40.

As shown in FIG. 11B, in the cross section cut along E-E, the fourth elastic sheet 24 on the first housing unit 13 side of the hinge 20 is fixed to the first housing unit 13 by the bonding member 40, and the fourth elastic sheet 24 on the first display unit 12 side of the hinge 20 is fixed to the second display unit 12 by the bonding member 40.

FIGS. 12A and 12B are diagrams showing variations of FIGS. 11A and 11B relating to the hinge according to the second embodiment of the present invention. As shown in FIGS. 12A and 12B, a third elastic sheet 23' and a fourth elastic sheet 24' may be provided in two layers. The number of the third elastic sheets 23' and the fourth elastic sheets 24' is not limited to two, an a plurality, three or more, of the third elastic sheets 23' and the fourth elastic sheets 24' may be provided.

In the second embodiment of the present invention, in a state where the electronic device 1 is opened 180°, the first elastic sheet 21 and the second elastic sheet 22 of the hinge 20 are substantially parallel with each other in the first section 20a of the hinge 20. On the other hand, in a state where the electronic device 1 is opened 180°, the third elastic sheet 23 in the second section 20b of the hinge 20 and the fourth elastic sheet 24 in the third section 20c are not parallel with each other.

Like in the second embodiment, the second section 20b having the third elastic sheet 23 and the third section 20c having the fourth elastic sheet 24 are disposed alternately in the hinge 20, so that an advantage of improved durability against bending of the hinge 20 can be obtained.

In the first and second embodiments and drawings, the case where the electronic device 1 has two screens is exemplified. However, the present invention is not limited to this example, and the hinge 20 of the present invention can be used for an electronic device having three screens or more, and the screens may be connected by the hinge 20. For example, when the electronic device 1 includes three screens, the electronic device 1 can be folded in three by the hinges 20 provided between the screens.

That is, the configuration may be such that the electronic device 1 includes at least a first display unit, a second display unit, and a third display unit, and at least a first housing unit, a second housing unit, and a third housing unit. The hinge includes a first elastic sheet that connects the first display unit and the second display unit, and the second display unit and the third display unit, a second elastic sheet that connects the first housing unit and the second housing unit, and the second housing unit and the third housing unit, and a printed circuit board provided between the first elastic sheet and the second elastic sheet.

The configuration may also be such that the electronic device 1 includes at least a first display unit, a second display unit, and a third display unit, and at least a first housing unit, a second housing unit, and a third housing unit. The hinge includes at least one or more first sections, at least one or more second sections, and at least one or more third sections. The first section of the hinge includes a first elastic sheet that connects the first display unit and the second display unit, and the second display unit and the third display unit, a second elastic sheet that connects the first housing unit and the second housing unit, the second housing unit and the third housing unit, and a printed circuit board provided between the first elastic sheet and the second elastic sheet. The second section of the hinge includes a third elastic sheet that connects the first display unit and the second housing unit, and the second display unit and the third housing unit. The third section of the hinge includes a fourth elastic sheet that connects the first housing unit and the second display unit, and the second housing unit and the third display unit.

In the first to third embodiments and drawings, the case of using the hinge 20 for connecting screens is described. However, the present invention is not limited to this example. The hinge 20 of the present invention may be used not only for connecting screens but also for connecting electronic device main bodies including a screen, a keyboard, and the like. The hinge 20 of the present invention may be used to connect an electronic device main body including a control unit and a lid unit including a battery.

The above description has been made on the embodiment. However, the present invention is not limited to the embodiments. It is obvious for a person skilled in the art that a variety of changes and modifications can be made within the spirit of the present invention and the gist of the claims.

### REFERENCE SIGNS LIST

- 1: Electronic device
- 11: First display unit
- 12: Second display unit
- 13: First housing unit
- 14: Second housing unit
- 20: Hinge
- 21: First elastic sheet
- 22: Second elastic sheet
- 30: Printed circuit board
- 31: Main control unit
- 32: Sub-control unit
- 33: Battery unit
- 34: Master device
- 35: Slave device
- 40: Bonding member
- 41: End portion
- 50: Space
- 60: Space

## Claims

1. A hinge for an electronic device,
the electronic device comprising at least a first display unit and a second display unit, and at least a first housing unit and a second housing unit, the hinge comprising:
a first elastic sheet that connects the first display unit and the second display unit;
a second elastic sheet that connects the first housing unit and the second housing unit; and
a printed circuit board provided between the first elastic sheet and the second elastic sheet.

2. The hinge for an electronic device according to claim 1, wherein
the printed circuit board extends from between the first display unit and the first housing unit to between the second display unit and the second housing unit.

3. The hinge for an electronic device according to claim 1 or 2, wherein
the first elastic sheet and the second elastic sheet are made from rubber.

4. The hinge for an electronic device according to any one of claims 1 to 3, wherein
the printed circuit board is a flexible printed circuit board.

5. An electronic device including the hinge for an electronic device according to any one of claims 1 to 4, the electronic device comprising:
a sub-control unit attached to the first housing unit; and
a main control unit that is attached to the second housing unit and controls the sub-control unit, wherein
the sub-control unit and the main control unit are connected by the printed circuit board.

6. A hinge for an electronic device,
the electronic device comprising at least a first display unit and a second display unit, and at least a first housing unit and a second housing unit,
the hinge comprising at least one or more first sections, at least one or more second sections, and at least one or more third sections, wherein
the first section of the hinge comprises:
a first elastic sheet that connects the first display unit and the second display unit;
a second elastic sheet that connects the first housing unit and the second housing unit; and
a printed circuit board provided between the first elastic sheet and the second elastic sheet,
the second section of the hinge comprises a third elastic sheet that connects the first display unit and the second housing unit, and
the third section of the hinge comprises a fourth elastic sheet that connects the first housing unit and the second display unit.

7. The hinge for an electronic device according to claim 6, wherein
the printed circuit board extends from between the first display unit of the first section of the hinge and the first housing unit to between the second display unit and the second housing unit.

8. The hinge for an electronic device according to claim 6 or 7, wherein
the first to fourth elastic sheets are made from rubber.

9. The hinge for an electronic device according to any one of claims 6 to 8, wherein
the printed circuit board is a flexible printed circuit board.

10. The hinge for an electronic device according to any one of claims 6 to 9, wherein
the second section of the hinge and the third section of the hinge are disposed alternately in a longitudinal direction of the hinge.

11. An electronic device including the hinge for an electronic device according to any one of claims 6 to 10, the electronic device comprising:
a sub-control unit attached to the first housing unit; and
a main control unit that is attached to the second housing unit and controls the sub-control unit, wherein
the sub-control unit and the main control unit are connected by the printed circuit board.
